# EUROPEAN PATENT SPECIFICATION

(11) **EP 4 117 410 B1**
(45) Date of publication and mention of the grant of the patent: **11.11.2026**
(21) Application number: 20922857.6
(22) Date of filing: 03.03.2020
(51) Int. Cl.: H05K 13/02, B65G 1/04

(54) **MEMBER WAREHOUSE**
MITGLIEDERLAGER
ENTREPÔT D'ÉLÉMENTS

(43) Date of publication of application: 11.01.2023
(73) Proprietor: Fuji Corporation, Chiryu-shi, Aichi 472-8686 (JP)
(72) Inventor: ITO, Akinobu, Chiryu-shi, Aichi 472-8686 (JP)
(74) Representative: Grünecker Patent- und Rechtsanwälte PartG mbB
(86) International application number: PCT/JP2020/008904
(87) International publication number: WO 2021/176556

(56) References cited:
- EP-A2- 2 827 693
- WO-A2-2012/095825
- DE-U1- 202004 006 920
- JP-A- 2000 172 923
- JP-A- 2015 012 245
- JP-A- 2018 055 342
- JP-A- H05 330 616

## Description

### Technical Field

The present specification relates to a member warehouse that stores a member container accommodating multiple members related to a board product.

### Background Art

A technique for mass-producing board products by performing board work on a printed wiring board has become widespread. In addition, it is common to constitute a component mounting line by arranging multiple component mounters that performs component mounting work as board work. Many component mounters supply components using a carrier tape that accommodates multiple components. The carrier tape is procured in a state wound on a reel and stored in a member warehouse. In addition, a board package in which multiple boards are packed together is stored in the member warehouse. The reel or the board package correspond to a member container in which multiple members related to the board product are accommodated, and are conveyed into the member warehouse in a state in which a member code is attached thereto. Technological examples related to this type of member warehouse are disclosed in Patent Literature 1.

Patent Literature 1 discloses a component management system including an identification device that detects identification data of components supported by a tray received in an automatic warehouse. With this, it is considered that the components can be appropriately managed.
DE 20 2004 006 920 U1 relates to surface mounted device (SMD) technology. In particular, a shelf tower with a plurality of shelves is arranged in a housing. The housing has an opening for inputting and outputting SMD rolls and a barcode scan for reading a barcode on a newly inserted SMD roll (see paragraph [0023]). When conveying an SMD roll to its storage position, an article identifier of the roll and a position identifier of the storage position are stored in memory.
EP 2 827 693 A2 relates to a storing device for storing SMD components arranged on reels. An outer housing of the storage device has an opening for inputting an outputting reels. In the housing, storage areas for the reels are arranged in a drawer-type storage. Reels are identified by means of barcodes using a barcode reader. After identification, a reel is assigned a free storage area in a manner of dynamic storage area assignment. WO 2012/095825 A2 relates to a management system for product labels.
JP 2015-12245 A relates to mounting member management. In particular, a barcode created by a parts maker and identification information for identifying the electronic component reel are printed on barcode labels. Information of a storage shelf barcode label is captured to enable grasping the storage location of the electronic component reel on the storage shelf.
JP H05 330616 A relates to management of inventory information of a warehouse.
JP 2018 055342 A discloses an automated storage unit that sores a component reel where a code is recognized to a predetermined position.
JP 2000 172923 A relates to a product sales device. An expired product is carried to a product disposal port.

### Patent Literature

Patent Literature 1: JP-A-2019-91771

### Summary of the Invention

### Technical Problem

Incidentally, not limited to the technological examples of Patent Literature 1, generally, a member code attached to a member container is assigned by a component supplier, and represents the type and characteristic of member. However, since it is difficult for a manufacturer who manufactures a board product using a member to perform sufficient management only with the member code, an identification code that specifies an individual of the member container is assigned to perform management. The assignment and registration of the identification code to the newly procured member container are performed by an operator. In addition, the work that displays the registered identification code on the member container is performed by the operator using a label producing and attaching machine. The label producing and attaching machine has a function of producing an identification label corresponding to the identification code and attaching the identification label to the member container.

In the present specification, there is an object to provide a member warehouse in which labor saving is realized by automating at least a part of the assignment, registration, display, confirmation, or the like of an identification code when a member container is received.

### Solution to Problem

The scope of the invention is defined in the appended claims.

### Advantageous Effect of the Invention

In the member warehouse disclosed in the present specification, after the recognition section recognizes the member code attached to the member container, or when the confirmation section cannot confirm the identification code attached to the member container, the assignment section assigns the identification code to the member container. Therefore, at least a part of the work of assigning and registering the identification code that has been conventionally performed by the operator is automated, so that labor saving is realized.

### Brief Description of Drawings

[Fig. 1] Fig. 1 is a side cross-sectional view schematically illustrating a member warehouse according to a first embodiment.
[Fig. 2] Fig. 2 is a front perspective view of the member warehouse.
[Fig. 3] Fig. 3 is a plan cross-sectional view of a lower stage of the member warehouse as seen from the top side in the section III-III in Fig. 1.
[Fig. 4] Fig. 4 is a block diagram illustrating a control configuration of the member warehouse.
[Fig. 5] Fig. 5 is a diagram of an operation flow for explaining a reception operation of a reel into the member warehouse.
[Fig. 6] Fig. 6 is a side view schematically illustrating a state in which the reel is conveyed into a reception and delivery port.
[Fig. 7] Fig. 7 is a side view schematically illustrating a state in which a reel identification label is produced.
[Fig. 8] Fig. 8 is a side view schematically illustrating a state in which a gripping section approaches the reel.
[Fig. 9] Fig. 9 is a side view schematically illustrating an operation in which the gripping section grips the reel.
[Fig. 10] Fig. 10 is a side view schematically illustrating a state in which the reel is approached to a label producing and attaching machine.
[Fig. 11] Fig. 11 is a side view schematically illustrating an operation of attaching the reel identification label to the reel.
[Fig. 12] Fig. 12 is a side view schematically illustrating an operation of conveying out the reel from the reception and delivery port.
[Fig. 13] Fig. 13 is a front perspective view of a member warehouse according to a second embodiment.
[Fig. 14] Fig. 14 is a block diagram illustrating a control configuration of the member warehouse according to the second embodiment.

### Description of Embodiments

### 1. Device Configuration of Member Warehouse 1 according to First Embodiment

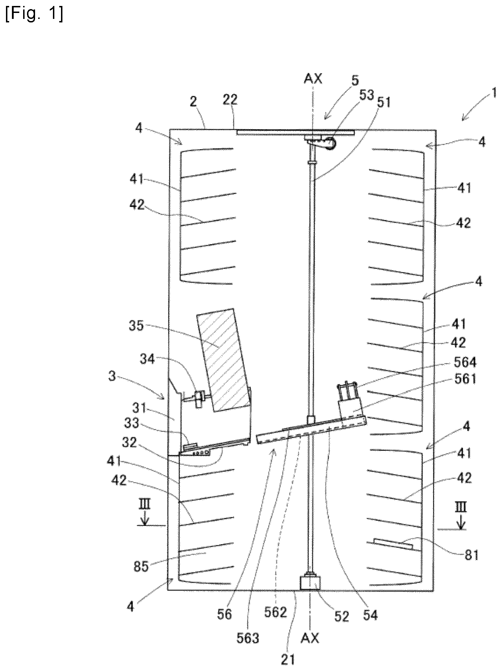

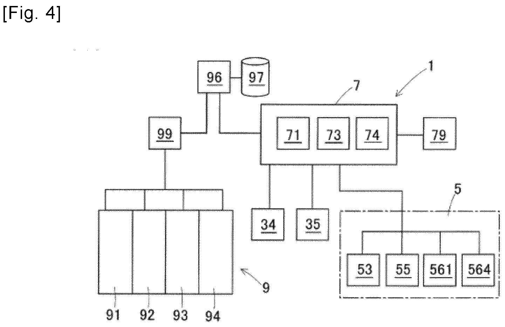

A device configuration of member warehouse 1 according to a first embodiment will be described with reference to Figs. 1 to 3. Member warehouse 1 receives, stores, and delivers reel 81 on which a carrier tape accommodating multiple components is wound. Reel 81 is used in component mounting line 9 in which one component mounter or multiple first to fourth component mounters (91 to 94) are arranged (refer to Fig. 4). Reel 81 is a form of a component container. Examples of other component containers include a board package in which multiple boards are packed together, and a tray that accommodates multiple large-sized components in an accommodation compartment of a lattice arrangement.

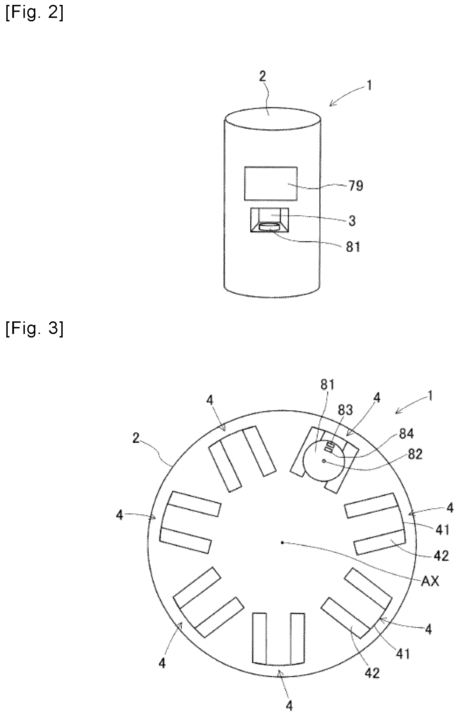

As illustrated in Figs. 2 and 3, reel 81 has a disk shape and has through hole 82 at the center thereof. Component type label 83 is attached to reel 81 at the time of procurement. Component type label 83 represents a member code representing member information related to the member, or is a form of a member code. Component type label 83 represents, for example, the types and characteristics, and the expiration date of the components accommodated in the carrier tape, the width dimension of the carrier tape, the size of reel 81, the manufacturing lot number, and the like. Component type label 83 is produced and attached by a component supplier. As component type label 83, a bar code, a two-dimensional code, a numeric string, or the like is used.

The manufacturer of the board product manages the procured reel 81 by attaching reel identification label 84 to the rear of the procured reel 81. Reel identification label 84 represents an identification code that specifies an individual of reel 81, or is a form of an identification code. Reel identification label 84 may be associated with incidental information desired by the manufacturer. As incidental information, member information represented by component type label 83 can be exemplified. With this, if reel identification label 84 is read in the following operations and works, it becomes unnecessary to read component type label 83 each time.

Member warehouse 1 includes warehouse housing 2, reception and delivery port 3, storage section 4, holding and moving section 5, and warehouse control section 7 (refer to Fig. 4). Warehouse housing 2 is formed in a rotationally symmetrical shape having vertical axis AX. In the first embodiment, as illustrated in Figs. 1 to 3, warehouse housing 2 is formed in a vertical cylindrical shape. The interior of warehouse housing 2 has a three-stage configuration including an upper stage, a middle stage, and a lower stage.

Seven storage sections 4 are provided side by side in a circumferential direction of the upper stage of warehouse housing 2. Reception and delivery port 3 and six storage sections 4 are provided side by side in the circumferential direction of the middle stage of warehouse housing 2. Seven storage sections 4 are provided side by side in the circumferential direction of the lower stage of warehouse housing 2. Therefore, a total of 20 storage sections 4 are provided. The number of storage sections 4 may be other than the above-mentioned. In addition, the arrangement and structure of storage section 4 in warehouse housing 2 can be variously modified.

Reception and delivery port 3 is disposed at an intermediate height of a front face of warehouse housing 2. Reception and delivery port 3 is a location where reel 81 is conveyed in and conveyed out. By positioning reception and delivery port 3 at the intermediate height, the average value of the conveying distances to all storage shelves 42 is minimized. Therefore, the average value of the time required for receiving and the average value of the time required for delivering are also minimized. A reception port may be disposed at the intermediate height of the front face of warehouse housing 2, and a delivery port may be separately disposed at the intermediate height of a rear face of warehouse housing 2. Reception and delivery port 3 includes opening section 31, loading plate 32, camera 34, and label producing and attaching machine 35.

Opening section 31 is formed in a horizontally long rectangular shape at an intermediate height position of the front face of warehouse housing 2. Loading plate 32 is provided behind a lower edge of the opening section 31. Loading plate 32 includes two plate materials separated from each other in a left-right direction. The two plate materials are disposed at a slight inclination angle such that the front side closer to opening section 31 is low and the rear side is high. Lower arm 562 of gripping section 56 described later can enter between the two plate materials. Positioning member 33 extending in the left-right direction is provided on an upper portion in the front side of loading plate 32. Positioning member 33 stabilizes the placement position of reel 81 placed on loading plate 32.

Camera 34 is disposed behind an upper edge of opening section 31, and performs imaging downward. Camera 34 has a light source for lighting, and has a function of automatically adjusting an imaging condition in accordance with an imaging target. Camera 34 captures an image of reel 81 on loading plate 32, and reads component type label 83 and reel identification label 84. In addition, camera 34 may have a function of determining the sizes of multiple types of reels 81, or confirming the placed positions and orientations.

Label producing and attaching machine 35 is disposed further behind camera 34 on the upper edge of opening section 31. Label producing and attaching machine 35 produces reel identification label 84 in accordance with the command. Label producing and attaching machine 35 further moves the produced reel identification label 84 to the lower attaching position, and attaches the produced reel identification label 84 to reel 81 positioned therebelow. Label producing and attaching machine 35 is a form of a code attaching device for providing the identification code that is physically recognizable (reel identification label 84) on a member container (reel 81).

Conventionally, label producing and attaching machine 35 is disposed outside the member warehouse and is operated by an operator. In the first embodiment, since label producing and attaching machine 35 is built in member warehouse 1, space saving in the factory is realized. In addition, since label producing and attaching machine 35 is controlled by warehouse control section 7 described later, the efforts for operating label producing and attaching machine 35 by the operator becomes unnecessary, so that labor saving is realized.

The internal configurations of twenty storage sections 4 are substantially the same. Each of storage sections 4 includes storage container 41 and five storage shelves 42. Storage container 41 is formed in a box shape that opens laterally toward axis AX. Five storage shelves 42 are disposed at equal intervals in an up-down direction in storage container 41. Storage shelf 42 is made of two plate materials separated from each other to the left and right in the same manner as loading plate 32, and has the same inclination angle as that of loading plate 32. Storage shelf 42 is a form of a storage position for storing reel 81. The inclination angles of storage shelf 42 and loading plate 32 prevent reel 81 from sliding off due to the influence of vibration or the like.

Member warehouse 1 stores reels 81 in a total of 100 storage shelves 42 of 20 storage sections 4, respectively. An actual member warehouse can store multiple reels 81. Each of storage shelves 42 is assigned and managed with an identification number. The identification number is assigned, for example, by a combination of the number specifying storage container 41 and the number representing the arrangement height of storage shelf 42.

Holding and moving section 5 moves inside warehouse housing 2 while holding reel 81. Holding and moving section 5 conveys reel 81 between reception and delivery port 3 and storage shelf 42 which is disposed in storage section 4. Holding and moving section 5 includes two lifting and lowering shafts 51, bearing portion 52, rotation driving section 53, lifting and lowering pivot section 54, lifting and lowering driving section 55 (refer to Fig. 4), gripping section 56, and the like. Two lifting and lowering shafts 51 extend in the up-down direction and are disposed symmetrically with respect to axis AX. In Fig. 1, two lifting and lowering shafts 51 overlap in the front-rear direction of the drawing, and only one shaft is displayed.

Bearing portion 52 is disposed on bottom plate 21 of warehouse housing 2. Bearing portion 52 supports the lower ends of two lifting and lowering shafts 51, and allows two lifting and lowering shafts 51 to revolve around axis AX. Rotation driving section 53 is disposed below top plate 22 of warehouse housing 2. Rotation driving section 53 supports the upper ends of two lifting and lowering shafts 51, and revolves two lifting and lowering shafts 51 around axis AX.

Lifting and lowering pivot section 54 is disposed in an area where storage section 4 does not exist at the center of warehouse housing 2, and is attached to straddle two lifting and lowering shafts 51. As two lifting and lowering shafts 51 revolve, lifting and lowering pivot section 54 rotates around axis AX. Lifting and lowering driving section 55 is attached to lifting and lowering pivot section 54. Lifting and lowering pivot section 54 is driven by lifting and lowering driving section 55 to lift and lower along two lifting and lowering shafts 51. Lifting and lowering pivot section 54 is formed to be long in the front-rear direction (in the left-right direction in Fig. 1), and has the same inclination angle as those of loading plate 32 and storage shelf 42.

Gripping section 56 is provided to be movable in a radial direction of lifting and lowering pivot section 54. Gripping section 56 includes gripping main body section 561, lower arm 562, upper arm 563, and gripping driving section 564. Gripping main body section 561 is movable on an upper surface of lifting and lowering pivot section 54 in the front-rear direction. As a result, the entire gripping section 56 moves back and forth in the radial direction about axis AX. Lower arm 562 is attached to a lower portion of gripping main body section 561 and extends forward. Upper arm 563 is attached to a higher position than lower arm 562 of gripping main body section 561 and extends forward. Upper arm 563 can be lifted and lowered with respect to gripping main body section 561. The length of upper arm 563 is shorter than the length of lower arm 562. Lower arm 562 and upper arm 563 have the same inclination angles as those of loading plate 32 and storage shelf 42, and are parallel to each other.

As illustrated in Fig. 1, when gripping main body section 561 is positioned at the rear end of lifting and lowering pivot section 54, the tip end of lower arm 562 does not protrude from lifting and lowering pivot section 54. Therefore, lower arm 562 does not prevent a pivot operation and a lifting and lowering operation of lifting and lowering pivot section 54. When gripping main body section 561 moves ahead of lifting and lowering pivot section 54, lower arm 562 protrudes from lifting and lowering pivot section 54 and enters between the two plate materials which constitute loading plate 32 or storage shelf 42.

Gripping driving section 564 is provided on an upper portion of gripping main body section 561. Gripping driving section 564 drives upper arm 563 to lift and lower. As a result, the separation distance between lower arm 562 and upper arm 563 in the up-down direction changes. Therefore, lower arm 562 and upper arm 563 can grip or release reel 81 placed on loading plate 32 or storage shelf 42 while sandwiching reel 81 from the top-bottom side. It is also possible to adopt a configuration in which gripping main body section 561 does not move but lower arm 562 and upper arm 563 expand and contract in the front-rear direction.

### 2. Configuration Related to Control of Member Warehouse 1

Next, a configuration related to the control of member warehouse 1 will be described. As illustrated in Fig. 4, member warehouse 1 includes warehouse control section 7. As illustrated in Fig. 2, operation display panel 79 is provided on the upper side of reception and delivery port 3 on the front face of warehouse housing 2. Operation display panel 79 includes an operation section operated by an operator and a display section that displays information to the operator. Operation display panel 79 functions as a man-machine interface for exchanging information between the operator and warehouse control section 7.

Warehouse control section 7 is a computer device that operates as software, which has CPU, a memory section, and the like. Warehouse control section 7 controls camera 34 and label producing and attaching machine 35. In addition, warehouse control section 7 controls rotation driving section 53, lifting and lowering driving section 55, gripping main body section 561, and gripping driving section 564 which are included in holding and moving section 5. In addition, warehouse control section 7 includes three control functional sections that comprehensively control the operation of member warehouse 1, that is, recognition section 71, assignment section 73, and memory section 74.

Warehouse control section 7 is communicatively connected to host management device 96. Host management device 96 is communicatively connected to line control section 99. Line control section 99 is communicatively connected to first to fourth component mounters (91 to 94) constituting component mounting line 9, respectively. Component mounting line 9 is a part of a production line for mass-producing a board product by mounting a component on a board. Line control section 99 manages the progress of the mounting work of first to fourth component mounters (91 to 94).

Host management device 96 manages changes in the type of board product to be produced and the type of original board. In addition, host management device 96 manages the procurement state, the storage state, the use state, and the like of reel 81 and the other members. The authority to assign an identification code to the newly procured reel 81 is assigned only to host management device 96. Host management device 96 assigns the identification code (information represented by reel identification label 84) to the new reel 81, creates data associated with the member code (information represented by component type label 83), and newly registers the data in database 97. In addition, host management device 96 frequently updates the registered data in accordance with the movement of the position of reel 81 or the progress of the use state. In addition, host management device 96 transmits and provides the registered data in response to an inquiry from warehouse control section 7 or line control section 99.

Recognition section 71 recognizes the member code (information represented by component type label 83) attached to reel 81 conveyed into reception and delivery port 3 by using camera 34. Assignment section 73 assigns an identification code that specifies an individual of the conveyed reel 81 to reel 81 and associates the identification code with the member code. Actually, assignment section 73 includes a part of the functions of host management device 96. From another viewpoint, assignment section 73 serves a predetermined function in cooperation with host management device 96.

Specifically, assignment section 73 first transmits the member code recognized by recognition section 71 to host management device 96. Host management device 96 assigns the identification code corresponding to the received member code to reel 81, newly registers the identification code in database 97, and returns the newly registered data to assignment section 73. Assignment section 73 receives the registered data. As a result, warehouse control section 7 can acquire the identification code of the conveyed reel 81. In addition, assignment section 73 controls label producing and attaching machine 35 (code attaching device).

Memory section 74 memorizes the identification code assigned to reel 81 and the identification number of storage shelf 42 (storage position) for storing reel 81, in association with each other. As a result, warehouse control section 7 can perform the deliver without error in response to the deliver command designating the identification code of reel 81. The control functions of recognition section 71, assignment section 73, and memory section 74 will be described in the following description of the operations.

### 3. Reception Operation of Reel 81 in Member Warehouse 1

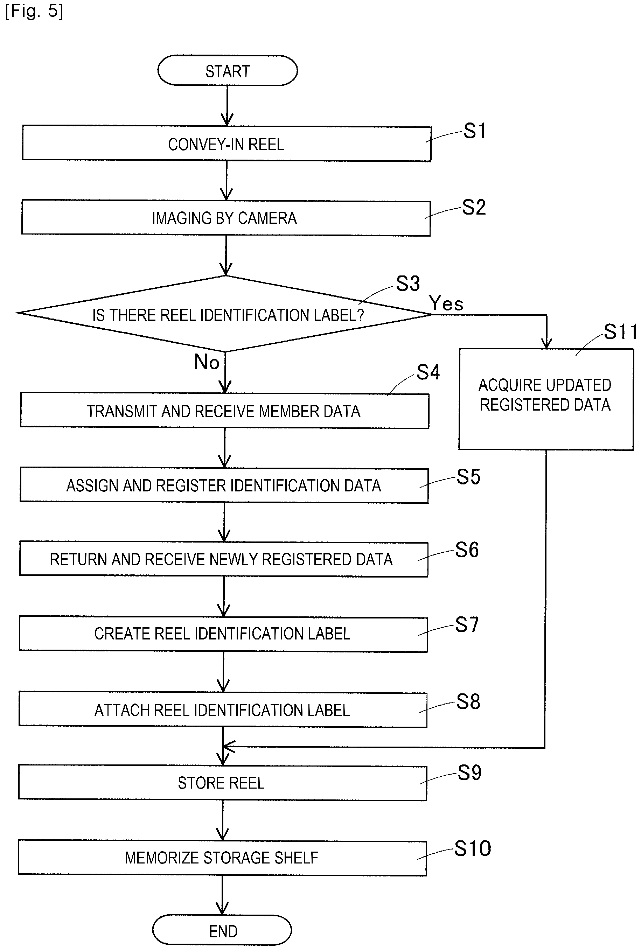

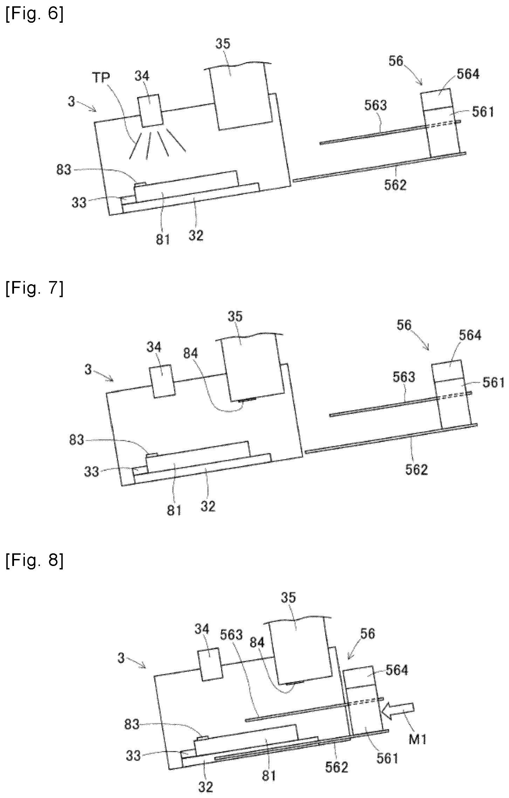

Next, a reception operation of reel 81 in member warehouse 1 will be described with reference to an operation flow in Fig. 5 and the time series conditions and operations in Figs. 6 to 12. The operation flow in Fig. 5 is mainly advanced by warehouse control section 7, and a part thereof is performed by the operator or host management device 96. Prior to the reception operation, lifting and lowering pivot section 54 is driven to a position facing reception and delivery port 3, gripping main body section 561 is positioned at the rear end of lifting and lowering pivot section 54, and upper arm 563 is driven to be lifted to expand the separation distance from lower arm 562.

In step S1 in Fig. 5, as illustrated in Fig. 6, reel 81 is conveyed into reception and delivery port 3, and then placed on loading plate 32. The placement of reel 81 is performed by the operator. Alternatively, the placement of reel 81 may be automatically performed by a conveyance robot. The presence of reel 81 is automatically recognized by a periodic imaging operation of camera 34, or is recognized by an input operation to operation display panel 79 by the operator.

In the next step S2, recognition section 71 causes camera 34 to capture an image (refer to reference symbol TP in Fig. 6), and recognizes component type label 83 and reel identification label 84 which are attached to reel 81. In the next step S3, recognition section 71 determines whether reel identification label 84 has already been attached to reel 81. Reel 81 to which reel identification label 84 is attached is intended to be used, and the execution of the operation flow proceeds to step S11.

On the other hand, reel 81 to which reel identification label 84 is not attached is a new product that has been newly procured. In this case, in step S4, assignment section 73 transmits the member code represented by component type label 83 to host management device 96. Host management device 96 receives the member code. In the next step S5, host management device 96 assigns the identification code corresponding to the member code to reel 81. In addition, host management device 96 associates the member code and the identification code with each other and newly registers them in database 97.

In the next step S6, host management device 96 returns the newly registered data to assignment section 73. Assignment section 73 receives the registered data and confirms the assigned identification code. In the next step S7, assignment section 73 commands label producing and attaching machine 35 to produce reel identification label 84 representing the identification code. Label producing and attaching machine 35 that has received the command creates reel identification label 84 and moves the same to the lower attaching position. This results in the situation of Fig. 7.

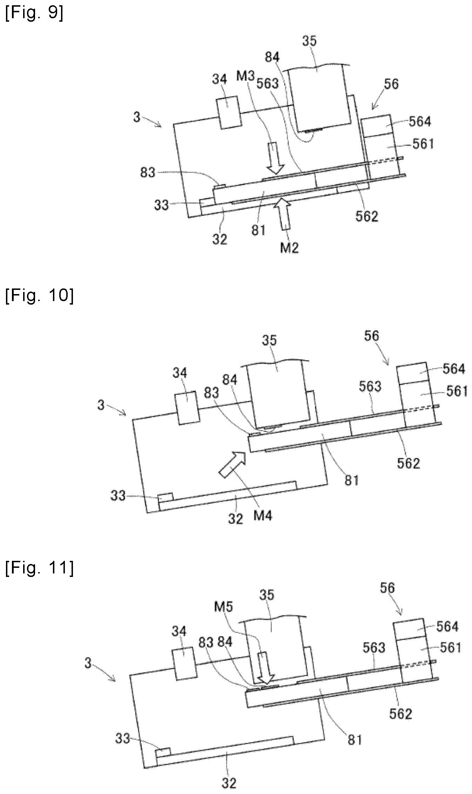

In the next step S8, warehouse control section 7 controls holding and moving section 5 to move reel 81. Specifically, warehouse control section 7 advances gripping section 56 as indicated by arrow M1 in Fig. 8, causes lower arm 562 to enter the lower side of reel 81, and causes upper arm 563 to enter the upper side of reel 81. Next, warehouse control section 7 moves upper arm 563 downward as indicated by arrow M3 while lifting lifting and lowering pivot section 54 as indicated by arrow M2 in Fig. 9. As a result, lower arm 562 and upper arm 563 grip reel 81.

Further, as indicated by arrow M4 in Fig. 10, warehouse control section 7 moves gripping section 56 backward while lifting lifting and lowering pivot section 54. As a result, reel 81 approaches label producing and attaching machine 35 and moves to the closest position directly below the attaching position. Next, assignment section 73 commands label producing and attaching machine 35 to attach reel identification label 84 to reel 81. Label producing and attaching machine 35 that has received the command attaches reel identification label 84 to reel 81 as indicated by arrow M5 in Fig. 11. The attaching position of reel identification label 84 may need not be an adjacent position of component type label 83.

In step S11 in a case where reel 81 is intended to be used in step S3, warehouse control section 7 acquires the latest registered data corresponding to the identification code (reel identification label 84) from host management device 96. After step S8 or step S11, the execution of the operation flow is merged into step S9.

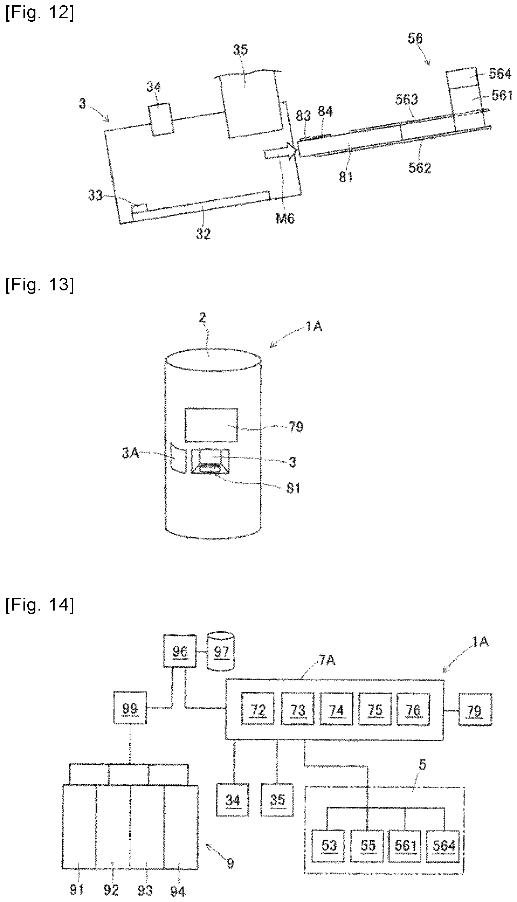

In step S9 following step S8, warehouse control section 7 further moves gripping section 56 backward as indicated by arrow M6 in Fig. 12. As a result, lifting and lowering pivot section 54 conveys out reel 81 from reception and delivery port 3. In step S9 following step S11, warehouse control section 7 controls holding and moving section 5 to directly shift from the state of Fig. 9 to the state of Fig. 12 without passing through Fig. 10 and Fig. 11. Thereafter, warehouse control section 7 drives lifting and lowering pivot section 54 to a position facing storage shelf 42 having the designated identification number, and advances gripping section 56.

As a result, reel 81 reaches storage shelf 42. Warehouse control section 7 expands the separation distance between lower arm 562 and upper arm 563, and causes reel 81 to be placed on storage shelf 42 for storage. The identification number of storage shelf 42 is designated autonomously by warehouse control section 7 or it is designated by following the input operation to operation display panel 79 by the operator. In the next step S10, memory section 74 memorizes the identification code assigned to reel 81 and the identification number of storage shelf 42 for storing reel 81, in association with each other. As a result, the reception operation of reel 81 is completed.

In the delivery operation of reel 81, reel 81 is gripped by storage shelf 42, and reel 81 is released at reception and delivery port 3. In the delivery operation, label producing and attaching machine 35 is not used. The delivered reel 81 is conveyed to component mounting line 9 for use. Alternatively, the delivered reel 81 is conveyed to a setup work area and loaded into a feeder device. The feeder device is conveyed to component mounting line 9 for use.

In member warehouse 1 according to the first embodiment, after recognition section 71 recognizes the member code (component type label 83) attached to reel 81, assignment section 73 assigns the identification code to reel 81. Therefore, at least a part of the work of assigning and registering the identification code (reel identification label 84) that has been conventionally performed by the operator is automated, so that labor saving is realized.

### 4. Member Warehouse 1A according to Second Embodiment

Next, the points different from those of the first embodiment will be mainly described with respect to member warehouse 1A according to the second embodiment. As illustrated in Fig. 13, member warehouse 1A according to the second embodiment includes discharge port 3A separate from reception and delivery port 3. Discharge port 3A is disposed side by side on the left of reception and delivery port 3, and may be disposed at other positions. In the second embodiment, discharge port 3A is provided in place of one storage section 4. Discharge port 3A has opening section 31 having the same shape as reception and delivery port 3, loading plate 32, and positioning member 33, and camera 34 and label producing and attaching machine 35 are omitted.

In addition, warehouse control section 7A according to the second embodiment includes five control functional sections illustrated in Fig. 14. That is, warehouse control section 7A includes confirmation section 72, assignment section 73, memory section 74, reception refusal section 75, and discharge operation section 76. Warehouse control section 7A performs control similar to the operation flow of the first embodiment illustrated in Fig. 5, and some of the control functions are different. The control function of memory section 74 is substantially the same as that of the first embodiment, and the description thereof will be omitted.

As more specifically describes the differences in control functions, in step S2 in Fig. 5, confirmation section 72 causes camera 34 to capture an image (refer to reference symbol TP in Fig. 6), and confirms reel identification label 84 (identification code) attached to reel 81. In addition, confirmation section 72 also confirms component type label 83 (member code) attached to reel 81. In the next step S3, it is determined whether confirmation section 72 has confirmed reel identification label 84. Further, it is determined whether confirmation section 72 has confirmed component type label 83. In a case where confirmation section 72 has confirmed both component type label 83 and reel identification label 84, it is determined that reel 81 is intended to be used, and the execution of the operation flow proceeds to step S11.

In addition, in a case where confirmation section 72 can confirm component type label 83 but cannot confirm reel identification label 84, it is determined that reel 81 is new, and the execution of the operation flow proceeds to the next step S4. Then, in a case where confirmation section 72 cannot confirm component type label 83, it is determined that an error has occurred. In this case, warehouse control section 7 displays an indication that an error has occurred on operation display panel 79 to notify the operator.

In step S4 and subsequent steps, assignment section 73 assigns the identification code to reel 81 when confirmation section 72 cannot confirm the identification code. Specifically, assignment section 73 transmits the confirmed member code to host management device 96 when confirmation section 72 cannot confirm the identification code but can confirm the member code. After host management device 96 newly registers the identification code corresponding to the member code, it receives the identification code.

Reception refusal section 75 operates at the time after the execution of step S2. Reception refusal section 75 refuses the reception of reel 81 that is not suitable for storage based on component type label 83 or reel identification label 84 attached to reel 81. For example, when member warehouse 1A does not have a desiccator function, reel 81 accommodating components requiring humidity management is not suitable for storage. In addition, an excessively large reel 81 or an excessively small reel 81 that does not match the size of storage shelf 42 is not suitable for storage. Whether reel 81 is suitable for storage can be easily determined based on the information represented by component type label 83 and reel identification label 84. Reception refusal section 75 displays an indication that the reception of reel 81 conveyed into reception and delivery port 3 is refused and a reason for the refusal on operation display panel 79, and requests the operator to collect reel 81.

In addition, discharge operation section 76 does not operate in the operation flow of Fig. 5, but operates independently. Discharge operation section 76 sends reel 81 that is no longer suitable for storage among the stored reels 81 to discharge port 3A based on reel identification label 84 (identification code) attached to reel 81. As reel 81 which is no longer suitable for storage, reel 81 that accommodates a component whose expiration date has expired can be exemplified. Discharge operation section 76 displays on operation display panel 79 an indication that reel 81 has been sent to discharge port 3A and a reason for the discharge, and requests the operator to perform the process.

Since member warehouse 1A includes discharge port 3A separately from reception and delivery port 3, reel 81 to be discharged does not obstruct a normal reception and delivery operation. However, the present invention is not limited to this, as a configuration in which discharge port 3A is not provided, discharge operation section 76 may deliver reel 81 that is no longer suitable for storage from reception and delivery port 3.

In the second embodiment, as in the first embodiment, at least a part of the work of assigning and registering the identification code (reel identification label 84) is automated, so that labor saving is realized. In addition, member warehouse 1A is provided with reception refusal section 75 and discharge operation section 76, so that the reel 81 to be stored can be constantly suitable.

### 5. Application and Modification of Embodiment

Although warehouse control section 7, host management device 96, and line control section 99 are exemplified in the configuration related to the control in Fig. 4, the hardware configuration can be variously modified. In addition, label producing and attaching machine 35 may be replaced with a code printing machine that directly prints the identification code corresponding to reel identification label 84 on reel 81. Further, the first and second embodiments are capable of various applications and modifications.

### Reference Signs List

1, 1A: Member warehouse, 2: Warehouse housing, 3: Reception and delivery port, 32: Loading plate, 34: Camera, 35: Label producing and attaching machine, 3A: Discharge port, 4: Storage section, 41: Storage container, 42: Storage shelf, 5: Holding and moving section, 51: Lifting and lowering shaft, 53: Rotation driving section, 54: Lifting and lowering pivot section, 55: Lifting and lowering driving section, 56: gripping section, 7, 7A: Warehouse control section, 71: Recognition section, 72: Confirmation section, 73: Assignment section, 74: Memory section, 75: Reception refusal section, 76: Discharge operation section, 79: Operation display panel, 81: Reel, 9: Component mounting line, 91 to 94: First to fourth component mounters, 96: Host management device, 99: Line control section

## Claims

1. A member warehouse (1, 1A) comprising:
a reception and delivery port (3) configured to receive and deliver a member container accommodating multiple members related to a board product;
a storage section (4) having multiple storage positions for storing the member container;
a recognition section (71) configured to recognize a member code which is attached to the member container conveyed into the reception and delivery port (3) and represents member information related to the accommodated members; and
a memory section (74) configured to memorize an identification code of the member container and the storage positions of the member container in association with each other;
**characterized by**
an assignment section (73) configured to assign the identification code that specifies an individual of the conveyed member container to the member container, and associate the identification code with the member code; and
a reception refusal section (75) configured to refuse reception of the member container which is not suitable for storage based on information represented by the identification code attached to the member container.

2. The member warehouse (1, 1A) according to claim 1, wherein
the assignment section(73) is configured to transmit the recognized member code to a host management device, and receive the identification code after the host management device newly registers the identification code corresponding to the member code.

3. A member warehouse (1, 1A) comprising:
a reception and delivery port (3) configured to receive and deliver a member container accommodating multiple members related to a board product; and
a storage section (4) having multiple storage positions for storing the member container; and
a memory section (74);
**characterized by**
a confirmation section (72) configured to confirm an identification code which is attached to the member container conveyed into the reception and delivery port and specify an individual of the member container;
an assignment section (73) configured to assign the identification code to the member container when the identification code is not confirmable by the confirmation section (72); and
a reception refusal section (75)configured to refuse reception of the member container which is not suitable for storage based on information represented by the identification code attached to the member container;
wherein the memory section (74) is configured to memorize the identification code of the member container confirmed by the confirmation section (72) or assigned by the assignment section (73) and the storage positions of the member container in association with each other.

4. The member warehouse (1, 1A) according to claim 3, wherein
the confirmation section (72) is configured to also confirm a member code which is attached to the conveyed member container and represent member information related to the accommodated members, and
the assignment section (73) is configured to, when the identification code is not confirmable but the member code is confirmable by the confirmation section (72), transmit the confirmed member code to a host management device, and receive the identification code after the host management device newly registers the identification code corresponding to the member code.

5. The member warehouse (1, 1A) according to any one of claims 1 to 4, wherein
the assignment section (73) is configured to control a code attaching device that provides the identification code that is physically recognizable to the member container.

6. The member warehouse (1, 1A) according to any one of claims 1 to 5, further comprising
a discharge port (3A) provided separately from the reception and delivery port and configured to discharge the member container; and
a discharge operation section (76) configured to send the member container which is no longer suitable for storage among the stored member containers to the discharge port, based on the identification code attached to the member container.

7. The member warehouse (1, 1A) according to any one of claims 1 to 6, wherein
the member is a component to be mounted on a board, and the member container is a reel (81) on which a carrier tape that accommodates the multiple components is wound.

## Patentansprüche

1. Bauteillager (1, 1A), umfassend:
einen Annahme-Ausgabe-Anschluss (3), der so konfiguriert ist, dass er einen Bauteilbehälter annimmt und ausgibt, der mehrere mit einem Plattenprodukt zusammenhängende Bauteile aufnimmt;
einen Lagerungsabschnitt (4) mit mehreren Lagerungspositionen zum Lagern des Bauteilbehälters;
einen Erkennungsabschnitt (71), der so konfiguriert ist, dass er einen Bauteilcode erkennt, der an dem in den Annahme-Ausgabe-Anschluss (3) beförderten Bauteilbehälter angebracht ist und mit den aufgenommenen Bauteilen zusammenhängende Bauteilinformationen repräsentiert; sowie
einen Speicherabschnitt (74), der so konfiguriert ist, dass er einen Identifikationscode des Bauteilbehälters und die Lagerungspositionen des Bauteilbehälters in Zuordnung zueinander speichert;
**gekennzeichnet durch**
einen Zuweisungsabschnitt (73), der so konfiguriert ist, dass er den Identifikationscode der einen einzelnen beförderten Bauteilbehälter angibt, dem Bauteilbehälter zuweist, und den Identifikationscode dem Bauteilcode zuordnet; sowie
einen Annahmeverweigerungsabschnitt (75), der so konfiguriert ist, dass er Annahme des Bauteilbehälters, der für Lagerung nicht geeignet ist, basierend auf Informationen verweigert, die durch den an dem Bauteilbehälter angebrachten Identifikationscode repräsentiert werden.

2. Bauteillager (1, 1A) nach Anspruch 1, wobei
der Zuweisungsabschnitt (73) so konfiguriert ist, dass er den erkannten Bauteilcode zu einer Host-Verwaltungsvorrichtung sendet und den Identifikationscode empfängt, wenn die Host-Verwaltungsvorrichtung den dem Bauteilcode entsprechenden Identifikationscode neu registriert.

3. Bauteillager (1, 1A), umfassend:
einen Annahme-Ausgabe-Anschluss (3), der so konfiguriert ist, dass er einen Bauteilbehälter annimmt und ausgibt, der mehrere mit einem Plattenprodukt zusammenhängende Bauteile aufnimmt; sowie
einen Lagerungsabschnitt (4) mit mehreren Lagerungspositionen zum Lagern des Bauteilbehälters; und
einen Speicherabschnitt (74);
**gekennzeichnet durch**
einen Bestätigungsabschnitt (72), der so konfiguriert ist, dass er einen Identifikationscode bestätigt, der an dem in den Annahme-Ausgabe-Anschluss beförderten Bauteilbehälter angebracht ist und einen einzelnen Bauteilbehälter angibt;
einen Zuweisungsabschnitt (73), der so konfiguriert ist, dass er den Identifikationscode dem Bauteilbehälter zuweist, wenn der Identifikationscode durch den Betätigungsabschnitt (72) nicht bestätigt werden kann; und
einen Annahmeverweigerungsabschnitt (75), der so konfiguriert ist, dass er Annahme des Bauteilbehälters, der für Lagerung nicht geeignet ist, basierend auf Informationen verweigert, die durch den an dem Bauteilbehälter angebrachten Identifikationscode repräsentiert werden;
wobei der Speicherabschnitt (74) so konfiguriert ist, dass er den durch den Betätigungsabschnitt (72) bestätigten oder durch den Zuweisungsabschnitt (73) zugewiesenen Identifikationscode des Bauteilbehälters und die Lagerungspositionen des Bauteilbehälters in Zuordnung zueinander speichert.

4. Bauteillager (1, 1A) nach Anspruch 3, wobei
der Bestätigungsabschnitt (72) so konfiguriert ist, dass er auch einen Bauteilcode bestätigt, der an dem beförderten Bauteilbehälter angebracht ist und mit den aufgenommenen Bauteilen zusammenhängende Bauteilinformationen repräsentiert, und der Zuweisungsabschnitt (73) so konfiguriert ist, dass er, wenn der Identifikationscode durch den Bestätigungsabschnitt (72) nicht bestätigt werden kann, aber der Bauteilcode bestätigt werden kann, den bestätigten Bauteilcode zu einer Host-Verwaltungsvorrichtung sendet und den Identifikationscode empfängt, wenn die Host-Verwaltungsvorrichtung den dem Bauteilcode entsprechenden Identifikationscode neu registriert.

5. Bauteillager (1, 1A) nach einem der Ansprüche 1 bis 4, wobei
der Zuweisungsabschnitt (73) so konfiguriert ist, dass er eine Code-Anbringungsvorrichtung steuert, die dem Bauteilbehälter den Identifikationscode bereitstellt, der physisch erkannt werden kann.

6. Bauteillager (1, 1A) nach einem der Ansprüche 1 bis 5, das des Weiteren umfasst:
einen Auslassanschluss (3A), der getrennt von dem Annahme-Ausgabe-Anschluss vorgesehen und zum Auslassen des Bauteilbehälters konfiguriert ist; sowie
einen Auslass-Funktionsabschnitt (76), der so konfiguriert ist, dass er von den gelagerten Bauteilbehältern den Bauteilbehälter, der nicht mehr für Lagerung geeignet ist, basierend auf dem an dem Bauteilbehälter angebrachten Identifikationscode zu dem Auslassanschluss sendet.

7. Bauteillager (1, 1A) nach einem der Ansprüche 1 bis 6, wobei
das Bauteil eine an einer Platte zu montierende Komponente ist und der Bauteilbehälter eine Rolle (81) ist, auf die ein Trägerband aufgewickelt ist, das die mehreren Komponenten aufnimmt.

## Revendications

1. Entrepôt d'éléments (1, 1A) comprenant:
un point de réception et de livraison (3) configuré pour recevoir et livrer un conteneur d'éléments pouvant accueillir plusieurs éléments liés à un produit de panneau;
une section de stockage (4) comportant plusieurs emplacements de stockage pour stocker le conteneur d'éléments;
une section de reconnaissance (71) configurée pour reconnaître un code d'élément qui est fixé au conteneur d'éléments acheminé vers le point de réception et de livraison (3) et qui représente des informations d'éléments liées aux éléments logés; et
une section de mémoire (74) configurée pour mémoriser un code d'identification du conteneur d'éléments et les emplacements de stockage de ce conteneur en association les uns avec les autres;
**caractérisé par**
une section d'attribution (73) configurée pour attribuer au conteneur d'éléments le code d'identification qui spécifie un exemplaire individuel du conteneur d'éléments acheminé, et pour associer ce code d'identification au code d'élément; et
une section de refus de réception (75) configurée pour refuser la réception du conteneur d'éléments qui n'est pas conçu pour le stockage sur la base des informations représentées par le code d'identification attaché au conteneur d'éléments.

2. Entrepôt d'éléments (1, 1A) selon la revendication 1, dans lequel
la section d'attribution (73) est configurée pour transmettre le code d'élément reconnu à un dispositif de gestion hôte, et pour recevoir le code d'identification après que le dispositif de gestion hôte a nouvellement enregistré le code d'identification correspondant au code d'élément.

3. Entrepôt d'éléments (1, 1A) comprenant:
un point de réception et de livraison (3) configuré pour recevoir et livrer un conteneur d'éléments contenant plusieurs éléments liés à un produit de carte; et
une section de stockage (4) comportant plusieurs emplacements de stockage pour stocker le conteneur d'éléments; et
une section de mémoire (74);
**caractérisé par**
une section de confirmation (72) configurée pour confirmer un code d'identification qui est apposé sur le conteneur d'éléments acheminé vers le point de réception et de livraison et pour identifier individuellement ledit conteneur d'éléments;
une section d'attribution (73) configurée pour attribuer le code d'identification au conteneur d'éléments lorsque le code d'identification ne peut pas être confirmé par la section de confirmation (72); et
une section de refus de réception (75) configurée pour refuser la réception du conteneur d'éléments qui n'est pas conçu pour le stockage sur la base des informations représentées par le code d'identification apposé sur le conteneur d'éléments;
dans lequel la section de mémoire (74) est configurée pour mémoriser le code d'identification du conteneur d'éléments confirmé par la section de confirmation (72) ou attribué par la section d'attribution (73), ainsi que les emplacements de stockage du conteneur d'éléments, en les associant les uns aux autres.

4. Entrepôt d'éléments (1, 1A) selon la revendication 3, dans lequel
la section de confirmation (72) est configurée pour confirmer également un code d'élément qui est associé au conteneur d'éléments acheminé et qui représente des informations d'éléments relatives aux éléments logés, et
la section d'attribution (73) est configurée pour, lorsque le code d'identification ne peut pas être confirmé mais que le code d'élément peut l'être par la section de confirmation (72), transmettre le code d'élément confirmé à un dispositif de gestion hôte, et recevoir le code d'identification après que le dispositif de gestion hôte a nouvellement enregistré le code d'identification correspondant au code d'élément.

5. Entrepôt d'éléments (1, 1A) selon l'une quelconque des revendications 1 à 4, dans lequel
la section d'affectation (73) est configurée pour commander un dispositif d'apposition de code qui appose le code d'identification, physiquement reconnaissable, sur le conteneur d'éléments.

6. Entrepôt d'éléments (1, 1A) selon l'une quelconque des revendications 1 à 5, comprenant en outre
un point de déchargement (3A) prévu séparément du point de réception et de livraison et configuré pour décharger le conteneur d'éléments; et
une section d'opération de déchargement (76) configurée pour acheminer vers le point de déchargement le conteneur d'éléments qui n'est plus apte au stockage parmi les conteneurs d'éléments stockés, sur la base du code d'identification apposé sur le conteneur d'éléments.

7. Entrepôt d'éléments (1, 1A) selon l'une quelconque des revendications 1 à 6, dans lequel
le composant est un élément destiné à être monté sur une carte, et le conteneur d'éléments est une bobine (81) sur laquelle est enroulé un ruban de transport qui reçoit les multiples composants.
